# EUROPÄISCHE PATENTSCHRIFT

(11) **EP 3 380 646 B1**
(45) Veröffentlichungstag und Bekanntmachung des Hinweises auf die Patenterteilung: **08.07.2020**
(21) Anmeldenummer: 16801225.0
(22) Anmeldetag: 24.11.2016
(51) Int. Cl.: C23C 16/448, C23C 16/30, C23C 16/40, C30B 25/02, C07F 5/00, C30B 29/02, C30B 29/16, C30B 35/00

(54) **VERFAHREN ZUR METALLORGANISCHEN GASPHASENABSCHEIDUNG UNTER VERWENDUNG VON LÖSUNGEN VON INDIUMALKYLVERBINDUNGEN IN KOHLENWASSERSTOFFEN**
METHOD FOR THE ORGANOMETALLIC GAS PHASE DEPOSITION UNDER USE OF SOLUTIONS OF INDIUMALKYL COMPOUNDS IN HYDROCARBONS
PROCEDE DE DEPOT CHIMIQUE EN PHASE VAPEUR ORGANOMETALLIQUE A L'AIDE DE SOLUTIONS DE COMPOSES D'INDIUM(ALKYL) DANS DES HYDROCARBURES

(30) Priorität: 25.11.2015 EP 15196340
(43) Veröffentlichungstag der Anmeldung: 03.10.2018
(73) Patentinhaber: UMICORE AG & CO. KG, 63457 Hanau-Wolfgang (DE)
(72) Erfinder: KOCH, Joerg, 35232 Dautphetal (DE); BRIEL, Oliver, 63755 Alzenau (DE)
(86) Internationale Anmeldenummer: PCT/EP2016/078705
(87) Internationale Veröffentlichungsnummer: WO 2017/089477

(56) Entgegenhaltungen:
- CA-A- 668 724
- JP-A- 2010 001 247
- JP-A- 2011 196 956
- US-A- 5 300 320
- US-A1- 2006 226 075
- US-A1- 2011 045 166
- US-A1- 2013 220 221
- US-A1- 2014 141 170
- Caroline E. Knapp ET AL: "Aerosol-Assisted Chemical Vapor Deposition of Transparent Conductive Gallium-Indium-Oxide Films", Chemistry of materials, vol. 23, no. 7, 12 April 2011 (2011-04-12) , pages 1719-1726, XP055679541, ISSN: 0897-4756, DOI: 10.1021/cm102292b

## Beschreibung

Die Erfindung betrifft Verfahren zur Herstellung einer Indium-haltigen Schicht durch metallorganische Gasphasenabscheidung, wobei die Indium-haltige Schicht in einer Reaktionskammer auf einem Substrat erzeugt wird, wobei das Zuführen der Indium-haltigen Vorläuferverbindung in einer Lösung erfolgt. Die Erfindung betrifft auch die Lösungen, Verwendungen solcher Lösungen und Vorrichtungen zur Durchführung des Verfahrens.

### Stand der Technik

Die metallorganische Gasphasenabscheidung, und insbesondere die metallorganische Gasphasenepitaxie sind wichtige Verfahren, um dünne Schichten von Metallen oder Metallverbindungen auf Substraten zu erzeugen. Die Verfahren werden insbesondere in der Halbleiterindustrie eingesetzt. Dabei werden metallorganische Verbindungen, gegebenenfalls in Verbindung mit weiteren reaktiven Verbindungen, in Prozesskammern eingeführt, wo bei Unterdruck bis Normaldruck eine Reaktion auf der Oberfläche erwärmter Substrate stattfindet, die zur Abscheidung der Schicht führt. Die Verfahren wurden in den 70er und 80er Jahren entwickelt und seitdem stetig verbessert. So ist es heute möglich, eine Vielzahl von Halbleiterkristallen, amorphen Schichten und metallischen Verbindungen auf Substraten abzuscheiden. Für eine Übersicht wird beispielhaft auf das "Handbook of Thin Film Deposition - Processes and Technologies", 2. Auflage 2001, Herausgeber: Krishna Seshan, Kapitel 4, S. 151-203, von J. Zilko verwiesen.

Zur Erzeugung von Indiumschichten werden üblicherweise Indiumalkylverbindungen als Vorläuferverbindungen eingesetzt. Im Stand der Technik wird oft festes Trimethylindium eingesetzt, das als Feststoff einen ausreichenden Dampfdruck aufweist und in Halbleiterschichten kaum Verunreinigungen oder unerwünschte Dotierungen verursacht. Dabei wird festes Trimethylindium in Edelstahlzylindern vorgelegt. Diese sind mit mindestens einem Gaseinlass und Gasauslass versehen. Ein inertes Trägergas (vornehmlich Wasserstoff oder Stickstoff) wird durch den Gaseinlass geleitet und kommt in dem Zylinder mit dem festen TMI in Kontakt, das sich dabei im Trägergas anreichert. Der Massendurchsatz von TMI in der Gasphase, der am Gasauslass erreicht wird, hängt unter anderem vom Trägergasfluß, von der Temperatur des TMI und vom Druck ab.

Solche Verfahren sind mit zahlreichen Problemen verbunden. Trimethylindium ist ein Feststoff mit einem Schmelzpunkt von 88°C. TMI ist pyrophor, was bedeutet, dass es bei Raumtemperatur und an der Luft heftig mit Sauerstoff reagiert. Die Handhabung von TMI, insbesondere in der flüssigen Phase, ist problematisch, da Lufteintrag in geschlossene Gefäße mit TMI zur Explosion führen kann. Dies erschwert nicht nur die Handhabung von TMI in dem Prozess, sondern auch die Herstellung, den Transport, die Lagerung, die Befüllung der Anlage, die Dosierung oder die Entfernung und Entsorgung von Prozessrückständen .

Außerdem ist nachteilig, dass die Menge der festen Indiumverbindung, die pro Zeiteinheit in die Gasphase übergeht, gering ist und nicht beliebig erhöht werden kann. Daher ist die Wachstumsrate bei der Herstellung von Indium-enthaltenden Schichten mittels Gasphasenabscheidung sehr limitiert.

Ein weiterer Nachteil ist, dass die aus festen Vorläuferverbindungen freigesetzte Menge an gasförmigem Indium nur schwierig dosiert und kontinuierlich eingestellt werden kann. So hängt die Freisetzung beispielsweise von der Oberfläche ab, die sich während des Verdampfungsprozesses verändert.

Bei den Verfahren mit festem TMI ist außerdem nachteilig, dass das TMI nicht vollständig genutzt werden kann, da bei niedrigem Füllstand eine optimale und gleichmäßige Sättigung der Gasphase nicht mehr erreicht werden kann. Außerdem ist nachteilig, dass in dem Verfahren das Gefäß mit dem TMI, das üblicherweise ein Edelstahlzylinder ist, nach Aufbrauchen des TMI in einem aufwändigen Zwischenschritt entleert und neu befüllt werden muss, um einen gleichmäßigen Eintrag von Indium zu gewährleisten. Dies führt dazu, dass bekannte Verfahren insgesamt aufwändig sind und relativ lange dauern.

Zur Lösung solcher Probleme schlägt Fannin et al., 1994 ("Constant indium delivery from trimethylindium-hexadecane slurry"; 1994, J. Electron. Mat., 23, 2, Seiten 93 bis 96) vor, das TMI aus einer Suspension in den Prozess einzuführen. Dabei beschreiben die Autoren ein Verfahren, bei dem festes TMI in N,N-Dimethyldodecylamin suspendiert vorgelegt wird. Die Suspension wird in einem Bubbler verdampft und mit einem Trägergas vermischt. Allerdings ist bei Verwendung solcher heteroorganischer Verbindungen problematisch, weil die Aminverbindung oder Zersetzungsprodukte davon in die Gasphase gelangen und in der Prozesskammer unerwünschte Nebenreaktionen induzieren können, was zu einer Dotierung oder Verunreinigung der Beschichtung führen kann. Dies gilt umso mehr, da TMI mit dem Lösungsmittel einen Komplex bildet. Außerdem werden die Probleme der Handhabung von festem TMI auch mit einer solchen Suspension nicht gelöst.

Alternativ schlagen die Autoren vor, festes TMI in Form einer Suspension in einem Hochsieder, nämlich Hexadecan, bereitzustellen. Auch dabei wird ein Bubbler verwendet, der gasförmiges TMI und Hexadecan freisetzt. Auch dadurch werden die grundlegenden Probleme bei der Handhabung von festem, pyrophorem TMI nicht gelöst. Allgemein ist zudem nachteilig, dass der energetische Aufwand bei der Verdampfung solcher Hochsieder relativ hoch ist, da spezielle Einrichtungen, wie Bubbler, und eine relativ hohe Temperatur benötigt werden. Da TMI und Hexadecan in unterschiedlichen Phasen vorliegen und aufgebraucht werden, ist eine kontinuierliche Freisetzung von TMI über längere Zeiträume nicht möglich und die freigesetzte Menge gasförmigen Indiums aus dem Feststoff ist niedrig. Insgesamt werden die Probleme der Handhabung von pyrophorem TMI somit allenfalls teilweise gelöst.

Die DE 10 2013 225 632 A1 beschreibt ein Verfahren zur metallorganischen Gasphasenabscheidung, bei dem zusätzlich Kohlenwasserstoffe in die Prozesskammer eingeführt werden, die bei hoher Temperatur reagieren und eine Dotierung des Produktes mit Kohlenstoff bewirken. Um die erforderliche Zersetzung der Kohlenwasserstoffe in freie Methylradikale zu erreichen, sind hohe Reaktionstemperaturen oberhalb 1000°C bis zu 1200°C erforderlich. Ein ähnliches Verfahren wird in der US 6,284,042 B1 beschrieben. Auch gemäß diesem Dokument wird ein Kohlenwasserstoff getrennt von der organometallischen Verbindung zugeführt, wonach in der Reaktionskammer bei hoher Temperatur und Zersetzung der Kohlenwasserstoffe eine chemische Reaktion stattfindet, die zur Dotierung des Produktes mit Kohlenstoff führt. Weiterer relevanter Stand der Technik ist in den Druckschriften CA 668 724 A, JP 2011 196956 A, US 2006/226075 A1, US 5 300 320 A, JP 2010 001247 A, US 2011/045166 A1, US 2013/220221 A1, US 2014/141170 A1 und Caroline E. Knapp ET AL: "Aerosol-Assisted Chemical Vapor Deposition of Transparent Conductive Gallium-Indium-Oxide Films",Chemistry of materials, Bd. 23, Nr. 7, 12. April 2011 (2011-04-12), Seiten 1719-1726 offenbart.

Insgesamt besteht ein Bedürfnis nach verbesserten Verfahren zur Herstellung von Indium-enthaltenden Schichten durch metallorganische Gasphasenabscheidung, welche die oben beschriebenen Nachteile überwinden.

### Aufgabe der Erfindung

Der Erfindung liegt die Aufgabe zugrunde, Verfahren, Mittel, Verwendungen und Vorrichtungen bereitzustellen, welche die oben beschriebenen Nachteile überwinden. Dabei sollen Verfahren zur Herstellung von Indium-haltigen Schichten durch metallorganische Gasphasenabscheidung, insbesondere metallorganische Gasphasenepitaxie, bereitgestellt werden, die einfacher, prozessdienlicher und effizienter sind. Die Gefahren, die mit der Handhabung von festem Trimethylindium verbunden sind, sollen reduziert oder vermieden werden. Das in das Verfahren eingebrachte Indium soll gut handhabbar und dosierbar sein. Das Verfahren soll es ermöglichen, in der Gasphase und in der Reaktionskammer eine hohe Konzentration und einen hohen Massendurchsatz von Indium oder einer Indium enthaltenden Vorläuferverbindung einzustellen. Das Verfahren soll hinsichtlich der eingesetzten Materialien und des Arbeits- und Energieaufwandes effizient sein. Dabei sollen hochreine Indium-haltige Verbindungshalbleiterschichten erzeugt werden, die keine unerwünschten Dotierungen oder Verunreinigungen enthalten. Das Verfahren soll auch eine bessere Verwertung der Ausgangsstoffe ermöglichen.

### Offenbarung der Erfindung

Überraschenderweise wird die der Erfindung zugrunde liegende Aufgabe gelöst durch Verfahren und Verwendungen gemäß den Patentansprüchen.

Gegenstand der Erfindung ist ein Verfahren zur Herstellung einer Indium-haltigen Schicht durch metallorganische Gasphasenabscheidung, wobei die Indium-haltige Schicht in einer Reaktionskammer auf einem Substrat erzeugt wird, wobei das Indium dem Verfahren in Form einer Indium-haltigen Vorläuferverbindung zugeführt wird, welche die Formel InR3 aufweist, wobei die Reste R unabhängig voneinander ausgewählt sind aus Alkylresten mit 1 bis 6 C-Atomen, dadurch gekennzeichnet, dass das Zuführen der Indium-haltigen Vorläuferverbindung in einer Lösung, bestehend aus
(a) 5 bis 60 Gew.-% einer Verbindung der Formel InR₃, wobei R unabhängig voneinander ausgewählt ist aus Alkylresten mit 1 bis 6 C-Atomen, und
(b) 40 bis 95 Gew.-% mindestens eines Kohlenwasserstoffs, der 5 bis 8 Kohlenstoffatome aufweist, erfolgt.

Die metallorganische Gasphasenabscheidung (MOCVD, "metallo-organic chemical vapor deposition") ist ein Beschichtungsverfahren aus der Gruppe der chemischen Gasphasenabscheidung (CVD), bei dem die Abscheidung einer festen Schicht auf ein Substrat aus der chemischen Dampfphase unter Einsatz einer metallorganischen Vorläuferverbindung (Precursor) erfolgt. Dabei wurde überraschend festgestellt, dass hierbei kein Einbau hoher Mengen an Kohlenstoff oder Sauerstoff im Vergleich zu herkömmlich abgeschiedenen Schichten erfolgt, wenn die Indium-haltige Vorläuferverbindung wie oben beschrieben in Kombination mit einem Lösungsmittel eingesetzt wird.

In einer bevorzugten Ausführungsform ist die metallorganische Gasphasenabscheidung eine metallorganische Gasphasenepitaxie (MOVPE für "metal organic vapor phase epitaxy", auch "organo-metallic vapor phase epitaxy", OMVPE). Während durch MOCVD jede Abscheidung auf einem Substrat möglich ist, ist MOVPE ein Epitaxie-Verfahren und betrifft somit das kristalline Wachstum auf einem kristallinen Substrat. Die Verfahren, insbesondere MOVPE, werden insbesondere zur Abscheidung von halbleitenden Materialien verwendet.

Erfindungsgemäß wird eine Lösung einer Indiumalkylverbindung (Vorläuferverbindung) in einem Lösungsmittel verwendet. Dabei bedeutet der Begriff "Lösung" gemäß dem üblichen Sprachgebrauch, dass die Vorläuferverbindung tatsächlich in dem Lösungsmittel gelöst ist und nicht nur suspendiert ist. Dabei liegt die Lösung zumindest anfänglich, also beim Einbringen in das Verfahren und/oder vor der Überführung in die Gasphase, in flüssiger Form vor. Die Lösung wird dann im Laufe des Verfahrens in die Gasphase überführt, was vor oder während der Einbringung in die Reaktionskammer erfolgen kann. Es ist besonders bevorzugt, dass die Lösung aus der Indium-haltigen Vorläuferverbindung und dem Lösungsmittel besteht.

Erfindungsgemäß wird als Indium-haltige Vorläuferverbindung eine Indiumalkylverbindung der Formel InR₃ eingesetzt. Die Reste R sind unabhängig voneinander ausgewählt aus Alkylresten mit 1 bis 6 C-Atomen, insbesondere 1 bis 3 C-Atomen, insbesondere Methyl und/oder Ethyl. Beispielsweise ist die Vorläuferverbindung ausgewählt aus Trimethylindium, Triethylindium oder Ethyldimethylindium. Es können auch Gemische von solchen Indiumalkylverbindungen eingesetzt werden.

In einer bevorzugten Ausführungsform ist die Vorläuferverbindung Trimethylindium (TMI). Trimethylindium wird gemäß dem Stand der Technik vorrangig zur Erzeugung von Indium-haltigen Schichten durch metallorganische Gasphasenabscheidung oder -epitaxie verwendet. TMI ist ein weißer Feststoff mit einem Siedepunkt von 136°C.

Das Lösungsmittel weist mindestens einen Kohlenwasserstoff mit 5 bis 8 Kohlenstoffatomen auf. Bevorzugt besteht das Lösungsmittel aus mindestens einen Kohlenwasserstoff mit 5 bis 8 Kohlenstoffatomen. Gemäß dem üblichen Sprachgebrauch sind Kohlenwasserstoffe organische Verbindungen, die ausschließlich aus Kohlenstoff und Wasserstoff bestehen. Besonders bevorzugt besteht das Lösungsmittel aus einem Kohlenwasserstoff, der 5 bis 8 Kohlenstoffatome aufweist. Die Kohlenwasserstoffe Sie können Alkane, Aromaten oder Alkene sein. Sie können nicht zyklische oder zyklische Kohlenwasserstoffe sein. Die Alkane oder Alkene können unverzweigt oder verzweigt sein.

In einer bevorzugten Ausführungsform besteht das Lösungsmittel aus Kohlenwasserstoffen mit 5 bis 8 Kohlenstoffatomen, die bevorzugt Alkane oder Aromaten sind. Solche Kohlenwasserstoffe weisen im Allgemeinen Siedepunkte auf, die nur wenig unterhalb des Siedepunktes von Indiumalkylverbindungen liegen. Diese Kohlenwasserstoffe weisen einen vergleichsweise hohen Dampfdruck auf und lassen sich daher mit recht geringem Energieaufwand verdampfen. Außerdem liegen die Siedepunkte nicht weit von denen der Indiumalkylverbindungen entfernt, wodurch eine gleichmäßige und vollständige Verdampfung der Lösung begünstigt wird.

In einer bevorzugten Ausführungsform weist das Lösungsmittel mindestens ein Alkan auf. Besonders bevorzugt ist das Lösungsmittel ein Alkan oder ein Gemisch von Alkanen. Dabei kann das Alkan ausgewählt sein aus Pentan, Hexan, Heptan oder Octan. Das Alkan ist bevorzugt linear oder verzweigt. Alkane sind besonders als erfindungsgemäße Lösungsmittel geeignet, weil sie relativ reaktionsträge sind. Dadurch erfolgen auch bei relativ hohen Reaktionstemperaturen keine unerwünschten Reaktionen mit dem Lösungsmittel in der Gasphase, die beispielsweise zur Zersetzung und Einbringung von Kohlenstoff in die abzuscheidende Schicht führen könnten.

Besonders bevorzugt ist das Lösungsmittel ein Alkan mit 5 bis 8 Kohlenstoffatomen, also ausgewählt aus Pentan, Hexan, Heptan oder Octan, oder ein Gemisch davon. Dabei können beliebige Isomere eingesetzt werden, beispielsweise n-Pentan, Isopentan oder Neopentan; oder n-Hexan, 2-Methylpentan, 3-Methylpentan, 2,2-Dimethylbutan oder 2,3-Dimethylbutan. Analog können alle denkbaren Gemische von Heptan oder Oktan Isomeren eingesetzt werden. Besonders bevorzugt ist der Einsatz von Pentan.

In einer bevorzugten Ausführungsform weist das Lösungsmittel mindestens einen Aromaten auf. Besonders bevorzugt ist das Lösungsmittel ein Aromat oder ein Gemisch von Aromaten. Der Aromat kann beispielsweise ein Derivat des Benzols sein, das mit einer oder zwei Methylgruppen oder mit einer Ethylgruppe substituiert ist. Bevorzugt ist der Aromat ausgewählt aus Toluol, Xylol und Benzol. Aromaten sind besonders geeignet, da Indiumalkylverbindungen besonders gut in ihnen löslich sind. Solche niedermolekularen Aromaten sind auch relativ reaktionsträge und weisen Siedepunkte auf, die nur wenig unter denen der Indiumalkylverbindungen liegen. Bevorzugt wird als Lösungsmittel Toluol eingesetzt. Die Löslichkeit von TMI in Toluol beträgt bis zu 50 Gew.-%. Daher kann das Verfahren besonders effizient mit einer hoch konzentrierten Lösung durchgeführt werden und Nebenreaktionen können reduziert werden.

Besonders bevorzugt ist das Lösungsmittel ein Aromat mit 6 bis 8 Kohlenstoffatomen, insbesondere Toluol, Xylol oder Benzol. Solche Aromaten können insbesondere TMI in besonders großen Mengen lösen. Sie weisen auch Siedepunkte auf, die nur wenig unter dem Siedepunkt von TMI liegen.

Bevorzugt ist die Lösung ein Azeotrop. Alkane sind als Lösungsmittel auch bevorzugt, weil sie mit Trimethylindium Azeotrope bilden. Bei der Verdampfung von Azeotropen können gleichmäßige und relative hohe Konzentrationen der Komponenten in der Gasphase eingestellt werden.

Es ist dabei bevorzugt, dass das Lösungsmittel einen höheren Dampfdruck aufweist als die Indiumalkylverbindung. Der Siedepunkt des Lösungsmittels könnte dabei mindestens 10°C, mindestens 30°C oder mindestens 50°C unter dem Siedepunkt der Indiumalkylverbindung liegen. Bevorzugt liegen die Siepunkte nicht zu weit auseinander, bevorzugt um nicht mehr als 100°C, oder nicht mehr als 70°C, damit eine effiziente gemeinsame Verdampfung erfolgen kann. Bevorzugt beträgt der Unterschied der Siedepunkte von Lösungsmittel und Indiumalkylverbindung zwischen 10°C und 100°C, insbesondere zwischen 15°C und 70°C. Bei Verwendung von TMI mit einem Siedepunkt von etwa 134°C ist es bevorzugt, dass das Lösungsmittel einen Siedepunkt im Bereich von etwa 0°C bis etwa 120°C aufweist.

Es können auch Gemische der genannten Kohlenwasserstoffe eingesetzt werden. So können Gemische der genannten Alkane und/oder Aromaten mit 5 bis 8 Kohlenstoffen eingesetzt werden. Es kann auch aus technischen Gründen vorteilhaft sein, einen Kohlenwasserstoff einzusetzen, der geringe Verunreinigungen anderer Kohlenwasserstoffe aufweist, beispielsweise bis zu 20 Gew.-%, bis zu 10 Gew.-% oder bis zu 5 Gew.-%. Wenn kurzkettige Kohlenwasserstoffe eingesetzt werden, insbesondere mit 1 bis 4 Kohlenstoffatomen, so muss gegebenenfalls die Lösung vor Einführung in den Prozess gekühlt werden. Da dies zusätzliche Kühlungsenergie erfordert, sind solche Ausführungsformen weniger bevorzugt, und fallen daher nicht unter die Erfindung wie sie in den Ansprüchen definiert ist.

Erfindungsgemäß ist der Anteil der Vorläuferverbindung an der Lösung mindestens 5 Gew.-% oder mindestens 15 Gew.-%. Erfindungsgemäß enthält die Lösung bis zu 60 Gew.-% oder bis zu 55 Gew.-% der Vorläuferverbindung in gelöster Form. Erfindungsgemäß ist der Anteil der Vorläuferverbindung an der Lösung zwischen 5 bis 60 Gew.-%, bevorzugt zwischen 15 und 55 Gew.-%. Erfindungsgemäß sollte die Vorläuferverbindung vollständig gelöst sein. Dies ist vorteilhaft, denn selbst wenn nur ein kleiner Teil der Vorläuferverbindung nicht in gelöster Form vorliegt, könnte die Zusammensetzung der Gasphase in unerwünschterWeise verändert werden und bei einem kontinuierlichen Verfahren könnten Leitungen und Prozesseinrichtungen verstopft werden. Mit den erfindungsgemäßen Lösungen können die Probleme gemäß dem Stand der Technik mit festen Indiumalkylverbindungen vermieden werden.

Bei Verfahren der metallorganischen Gasphasenabscheidung und insbesondere der metallorganischen Gasphasenepitaxie erfolgt die Herstellung der Indium-haltigen Schichten in einer Reaktionskammer. In dieser liegt ein zu beschichtendes Substrat vor, das auf eine erhöhte Temperatur geheizt wird. Ein Gasstrom mit der Indium-haltigen Vorläuferverbindung und üblicherweise einem Trägergas wird in die Reaktionskammer eingeführt, wo die Vorläuferverbindung in der Gasphase vorzerlegt und radikalische Gruppen sich auf dem Substrat anlagern. Thermisch aktiviert haben die radikalischen Gruppen eine gewisse Bewegungsfreiheit auf dem Substrat, bis sich das Indiumatom an geeigneter Stelle in die Schicht einbaut. Der organische Rest wird mit elementarem Wasserstoff abgesättigt und eine stabile, volatile organische Verbindung entsteht. Dieses Restgas wird aus der Reaktionskammer abgeführt. Insoweit entspricht die erfindungsgemäße Vorrichtung bekannten Vorrichtungen. Es ist bevorzugt, dass die Lösung vor Einführung in die Reaktionskammer in die Gasphase überführt wird. In einer wenig bevorzugten Ausführungsform ist es auch denkbar, die Lösung erst bei Einführung in die Reaktionskammer zu verdampfen.

Die Überführung der Lösung in die Gasphase erfolgt bevorzugt in einem Verfahrensschritt, welcher der Reaktion in der Reaktionskammer vorgeschaltet ist. Bevorzugt wird zur Überführung in die Gasphase ein Verdampfer eingesetzt. In einem Verdampfer wird einer Lösung ausreichend thermische Energie zugeführt, um die Verdampfung zu erreichen. Bevorzugt wird die Lösung vor Einführung in die Reaktionskammer (4) mit einem Direktverdampfer (2) in die Gasphase überführt.

In einer bevorzugten Ausführungsform ist der Verdampfer ein Direktverdampfer. Die Lösung wird in dem Direktverdampfer unmittelbar und vollständig verdampft, wenn sie in den Verdampfer eintritt. Dabei sind Druck, Temperatur und Massendurchsatz so eingestellt, dass die Lösung direkt nach dem Einleiten vollständig in die Gasphase überführt wird. Die Lösung sammelt sich in also dem Direktverdampfer nicht in einem flüssigen Reservoir an. Dagegen erfolgt die Verdampfung gemäß dem Stand der Technik unter Verwendung von Bubblern aus einem Flüssigkeitsreservoir, wobei die Menge der verdampften Flüssigkeit durch die Prozessbedingungen im Bubbler (Druck, Temperatur, Flüssigkeitsoberfläche) gesteuert wird.

In dem Direktverdampfer wird die Lösung üblicherweise über einen Flüssigkeitsmengenregler (LFC -Liquid Flow Controller) in einem geheizten Mischventil unter Zugabe von inertem Trägergas verdampft. Der Direktverdampfer weist eine Heizeinrichtung auf. Damit wird thermische Energie zugeführt, um die bei der Verdampfung entstehende Verdunstungskälte zu kompensieren. Die kompakte Bauweise des Direktverdampfers kann unter anderem einen reaktornahen Einbau ermöglichen. Dadurch können ohne weiteres höhere Temperaturen eingestellt werden, bei denen auch Vorläuferverbindungen mit niedrigem Dampfdruck effizient in die Gasphase überführt und in die Prozesskammer eingeleitet werden können. Direktverdampfer sind im Stand der Technik bekannt und kommerziell erhältlich. Beispielsweise kann ein CEM System der Bronkhorst AG, CH, oder ein DirectVapor Produkt der Sempa Systems GmbH, DE, eingesetzt werden.

Bevorzugt weist der Direktverdampfer eine Temperatur von 0°C bis 100°C, insbesondere zwischen 10°C und 50°C, und/oder einen Druck von 50 mbar bis 1800 mbar auf. Dabei werden Temperatur und Druck aufeinander abgestimmt, so dass die vollständige Verdampfung der Lösung erfolgt und diese in der Gasphase verbleibt. Insbesondere werden die Prozessbedingungen so eingestellt, dass eine schnelle Verdampfung erfolgt, ohne dass flüssige oder feste Rückstände verbleiben.

Der Direktverdampfer kann eine Düse aufweisen. Dabei könnte der Direktverdampfer ein Direkteinspritzer (Direct Liquid Injection, DJI) sein. Direktverdampfer mit Düsen erlauben eine kontinuierliche, effiziente Überführung von Flüssigkeiten in die Gasphase.

Die Steuerung der Massendurchsätze in dem Prozess erfolgt bevorzugt über Durchflussregler und/oder Ventile. Die Steuerung erfolgt bevorzugt elektronisch.

Die Menge der direkt verdampften Lösung wird bevorzugt über einen Flüssigkeitsdurchflussregler gesteuert und kontrolliert. Besonders bevorzugt ist der Flüssigkeitsdurchflussregler ein Bestandteil des Direktverdampfers. Solche Regler, insbesondere in kompakter Form in Verbindung mit dem Direktverdampfer, erlauben eine optimale Steuerung des Massendurchsatzes im Hinblick auf den Bedarf in der Reaktionskammer.

Bevorzugt wird die verdampfte Lösung vor Einbringen in die Reaktionskammer mit einem Trägergas vermischt. Das Trägergas dient zur Unterstützung des Transports und zur Vermeidung von Kondensationseffekten. Es reagiert also bevorzugt nicht und ist in dem Prozess inert. Dabei können übliche Trägergase eingesetzt werden, wie Stickstoff, Wasserstoff oder Edelgase, wie Argon.

Die Menge des eingebrachten Trägergases wird bevorzugt über einen Gasdurchflussregler gesteuert und kontrolliert. Besonders bevorzugt ist der Gasdurchflussregler ein Bestandteil des Direktverdampfers. Solche Regler, insbesondere in kompakter Form in Verbindung mit dem Direktverdampfer, erlauben eine optimale Steuerung des Trägergases im Hinblick auf den Massendurchfluss der verdampften Lösung und den Bedarf in der Reaktionskammer.

Die verdampfte Lösung wird mit dem Trägergas bevorzugt in einer Mischkammer gemischt. Die Mischkammer weist bevorzugt ein Mischventil auf. Über das Mischventil können genaue und gleichmäßige Konzentrationen der Komponenten und der Indium-haltigen Vorläuferverbindung eingestellt werden. Bevorzugt ist die Mischkammer ein Bestandteil des Direktverdampfers. Bevorzugt erfolgt dabei die Verdampfung direkt in die Mischkammer. Dies bedeutet, dass die Lösung direkt in eine Kammer verdampft wird, in der die Gasphase mit einer weiteren Phase vermischt wird.

In einer besonders bevorzugten Ausführungsform wird ein Direktverdampfer eingesetzt, der einen Flüssigkeitsdurchflussregler, ein Gasdurchflussregler, eine Mischkammer und ein Mischventil aufweist. Bei dieser Ausführungsform sind die Komponenten zur Steuerung des Massendurchsatzes von Lösung und Trägergas und die Komponenten zum Vermischen der Gasphasen integrale Komponenten des Direktverdampfers. Eine solche Ausgestaltung ermöglicht eine kompakte, kontinuierliche und effiziente Aufbereitung von Indiumvorläuferverbindungen in Lösung für die Reaktion in der Reaktionskammer.

Bevorzugt wird bei dem erfindungsgemäßen Verfahren kein Bubbler eingesetzt. Gemäß dem Stand der Technik werden entsprechende Verfahren mit einem Bubbler (Dampfdrucksättiger) durchgeführt. Ein Bubbler umfasst ein Gefäß, das die zu verdampfende Flüssigkeit und die feste metallorganische Vorläuferverbindung enthält und durch das ein inertes Trägergas geleitet wird. Dabei ist nachteilig, dass eine präzise und kontinuierliche Verfahrensführung mit einem solchen Mehrkomponentensystem, enthaltend ein Lösungsmittel, eine Vorläuferverbindung und ein inertes Trägergas, nicht möglich oder zumindest relativ aufwändig ist. Dagegen kann das erfindungsgemäße Verfahren mit einem Direktverdampfer ohne Bubbler durchgeführt werden. Bei der Direktverdampfung ist die Vermischung der Lösung mit dem Trägergas besser steuerbar und das Verfahren kann über längere Zeiträume kontinuierlich durchgeführt werden, ohne dass ein Bubbler entleert oder neu befüllt werden muss.

Die Bedingungen in der Prozesskammer werden bevorzugt so eingestellt, dass keine oder im Wesentlichen keine parasitäre Dotierung mit Kohlenstoff erfolgt. Die als Lösungsmittel eingesetzten Kohlenwasserstoffe reagieren dabei nicht oder nur unwesentlich und beeinträchtigen das Produkt nicht in unerwünschter Weise. Dies ist möglich, wenn die Temperaturen in der Prozesskammer nicht zu hoch eingestellt werden, so dass keine Zersetzung der Kohlenwasserstoffe in reaktive Radikalen erfolgt. Bevorzugt erfolgt die Reaktion in der Reaktionskammer bei einer Temperatur, die kleiner als 950°C, mehr bevorzugt kleiner als 900°C oder insbesondere kleiner als 800°C ist. Dies ist insbesondere dadurch gegeben, dass für die Abscheidung Indium-haltiger Schichten Prozessbedingungen so eingestellt werden, dass Abscheidungstemperaturen unter 900°C gewählt werden.

Die Bedingungen in dem Verfahren und in der Prozesskammer werden so eingestellt, dass keine Kondensation von Flüssigkeit aus der Gasphase erfolgt, bevor diese aus der Reaktionskammer ausgeführt wird. Dabei werden die Prozessbedingungen, insbesondere Druck und Temperatur, nach dem Verdampfen der Lösung so eingestellt, dass sich die Gasphase oberhalb des Taupunktes befindet. Der Taupunkt ist bei einem gegebenen Druck die Temperatur, die unterschritten werden muss, damit sich aus der Gasphase Flüssigkeit als Niederschlag abscheidet. Bevorzugt ist die Temperatur der Gasphase mit der Indiumvorläuferverbindung in der Reaktionskammer größer als 100°C, mehr bevorzugt größer als 300°C oder größer als 400°C.

Die Temperatur in der Reaktionskammer kann beispielsweise zwischen 100 und 950°C oder zwischen 400 und 900°C liegen.

Das Lösungsmittel und/oder das inerte Trägergas könnten nach Austritt aus der Reaktionskammer wiederaufbereitet und wiederverwendet werden. Das Lösungsmittel könnte dabei kondensiert und abgetrennt werden.

Erfindungsgemäß ist es möglich, Vorläuferverbindungen zur Herstellung von Indium enthaltenden Schichten auf Substraten besonders gleichmäßig und in besonders hohen Massendurchsätzen in eine Reaktionskammer zur metallorganischen Gasphasenabscheidung einzuleiten. In der Reaktionskammer können dann nach bekannten Verfahren die Schichten auf dem Substrat erzeugt werden. Üblicherweise wird mindestens eine weitere reaktive Substanz in die Reaktionskammer eingeleitet, bevorzugt mindestens eine weitere Vorläuferverbindung. Beispielsweise können weitere reaktive Substanzen eingeführt werden, um Elemente der fünften Hauptgruppe, wie Stickstoff, Phosphor und/oder Arsen, auf das Substrat aufzubringen, oder Elemente der dritten Hauptgruppe, wie Aluminium oder Gallium, aufzubringen. Die Produkte können mehrschichtig sein und/oder die Indium-haltige Schicht kann weitere Elemente aufweisen, und dabei einen Mischkristall bilden oder dotiert werden. Solche Vorläuferverbindungen und Verfahren sind im Stand der Technik bekannt. Beispielhaft wird diesbezüglich verwiesen auf Stringfellow, Gerald B., "Organometallic Vapor-Phase Epitaxy: Theory and Practice", 1989, Published by Academic Press, ISBN 10: 0126738408.

Das erfindungsgemäße Verfahren kann zur Herstellung von Indium-haltigen Schichten eingesetzt werden. Die Schichten können Indiumverbindungen oder elementares Indium enthalten. Dabei können bekannte Verfahren mittels CVD (Chemical Vapour Deposition) eingesetzt werden, wobei beispielsweise Schichten aus ITO (Indium Tin Oxide) oder IGZO (Indium Gallium Zinc Oxide) hergestellt werden können.

In einer bevorzugten Ausführungsform, insbesondere bei der MOVPE, dient das Verfahren zur Herstellung von Halbleiterkristallen. Das Verfahren und das Produkt können dabei beispielsweise zur Herstellung von Lasern, Photodetektoren, Solarzellen, Phototransistoren, Photokathoden, Transistoren, Detektoren oder Modulatoren dienen.

Gegenstand der Erfindung ist auch die Verwendung einer Lösung, bestehend aus
(a) 5 bis 60 Gew.-%, insbesondere 15 bis 55 Gew.-%, einer Verbindung der Formel InR₃, wobei R unabhängig voneinander ausgewählt ist aus Alkylresten mit 1 bis 6 C-Atomen, wobei die Verbindung bevorzugt Trimethylindium ist, und
(b) 40 bis 95 Gew.-%, insbesondere 45 bis 85 Gew.-%, mindestens eines Kohlenwasserstoffs, der 5 bis 8 Kohlenstoffatome aufweist, zur Herstellung einer Indium-haltigen Schicht durch metallorganische Gasphasenabscheidung.

Bevorzugt besteht die Lösung aus 5 bis 60 Gew.-% Trimethylindium und 40 bis 95 Gew.-% mindestens eines Alkans oder eines Aromaten, das/der 1 bis 8 Kohlenstoffatome, bevorzugt 5 bis 8 Kohlenstoffatome, aufweist. Bevorzugt besteht die Lösung aus 5 bis 15 Gew.-% Trimethylindium und 85 bis 95 Gew.-% eines Alkans, der 5 bis 8 Kohlenstoffatome aufweist; oder aus 15 bis 60 Gew.-% Trimethylindium und 40 bis 85 Gew.-% eines Aromaten, der 6 bis 8 Kohlenstoffatome aufweist.

Die bevorzugten Lösungen entsprechen dabei den oben beschriebenen, die in dem erfindungsgemäßen Verfahren eingesetzt werden können. Um Wiederholungen zu vermeiden, wird ausdrücklich auf die obigen Ausführungen zur Ausgestaltung der Lösung und insbesondere zur Auswahl der Indiumalkylverbindungen und Lösungsmittel verwiesen.

Offenbart, jedoch nicht Gegenstand der Erfindung wie in den Ansprüchen definiert, ist auch eine Vorrichtung zur Durchführung des erfindungsgemäßen Verfahrens, umfassend
(A) Flüssigkeitszufuhrleitungen zum Zuführen der Lösung,
(B) einen Flüssigkeitsdurchflussregler zum Dosieren der Lösung,
(C) Mittel zum Zuführen des inerten Trägergases,
(D) einen Gasdurchflussregler zum Dosieren des Trägergases,
(E) einen Direktverdampfer mit einer Heizeinrichtung zum Verdampfen der Lösung und einer Mischkammer zum Vermischen mit dem Trägergas,
(F) eine Reaktionskammer zur Erzeugung einer Indium-haltigen Schicht auf einem Substrat, und
(G) Gaszufuhrleitungen zum Zuführen der Gasphase in die Reaktionskammer.

Die Regler (B) und (D) sind bevorzugt Komponenten des Direktverdampfers.

Zur weiteren Ausgestaltung der Vorrichtung wird auf die Ausführungen oben zur Verfahrensführung und auf das nachfolgende Beispiel verwiesen.

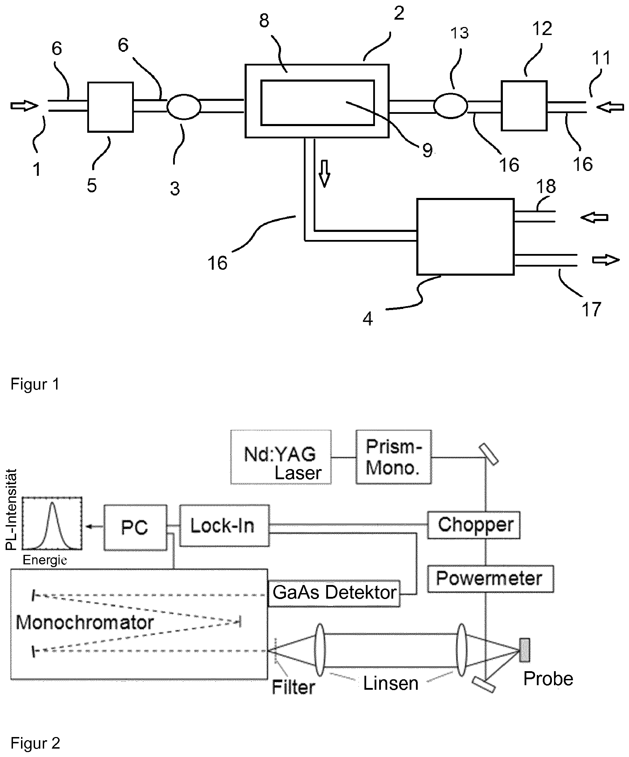

Figur 1 zeigt beispielhaft eine erfindungsgemäße Vorrichtung zur Durchführung des erfindungsgemäßen Verfahrens.

Figur 1 zeigt beispielhaft und schematisch eine Vorrichtung zur Durchführung des erfindungsgemäßen Verfahrens. Die Lösung wird über eine Zufuhr 1 in das Verfahren eingebracht. Dabei könnte eine flüssige Lösung von Trimethylindium (10 Gew.-%) in C5 bis C8-Alkanen oder in C6 bis C8-Aromaten eingesetzt werden. Die Lösung wird über Flüssigkeitszufuhrleitungen 6 in einen Direktverdampfer 2 geleitet, der eine Heizeinrichtung 8 und eine Mischkammer 9 aufweist. Die Flüssigkeitsmenge wird über einen Flüssigkeitsdurchflussregler 5 gesteuert und gemessen, der eine Komponente des Direktverdampfers oder diesem vorgeschaltet sein kann. Die Dosierung kann zusätzlich über ein Ventil 3 erfolgen. In dem Direktverdampfer 2 wird die Lösung durch Einstellung von geeigneten Prozessparametern, wie Temperatur und Druck, vollständig in die Gasphase überführt, wobei bevorzugt eine Temperatur von 20°C bis 80°C eingestellt wird. Dabei erfolgt die Verdampfung direkt in die Mischkammer, die ein integraler Bestandteil des Direktverdampfers ist. Die Lösung wird in der Mischkammer 9 mit einem inerten Trägergas vermischt, das über eine Zufuhr 11 und Gaszufuhrleitungen 16 eingeleitet wird. Die Menge des Trägergases wird über Gasdurchflussregler 12 und Ventil 13 gesteuert. Bevorzugt wird ein Direktverdampfer 2 eingesetzt, der den Flüssigkeitsdurchflussregler 5, den Gasdurchflussregler 12, die Mischkammer 9 und das Mischventil 13 als integrale Komponenten aufweist. Die Gasphase wird aus der Mischkammer 9 über Gaszufuhrleitungen 16 in die Reaktionskammer 4 eingebracht, gegebenenfalls über geeignete zusätzliche Prozessschritte wie Druckstufen. In der Reaktionskammer 4 erfolgt über bekannte Maßnahmen die Reaktion und Abscheidung von Indium, bzw. das Einbauen von Indium in den Mischkristall auf der Oberfläche des erwärmten Substrats. Das Reaktions- und das Trägergas durchströmen den Reaktor und werden über Gasabfuhrleitung 17 in das Abgassystem ausgetragen. Über eine oder mehrere weitere Gaszufuhrleitungen 18 können der Reaktionskammer weitere reaktive Substanzen in der Gasphase zugeführt werden, um Beschichtungen oder Mischkristalle aus mehreren Elementen herzustellen.

Die Erfindung löst die ihr zugrunde liegende Aufgabe. Es wird ein verbessertes, effizientes und relativ einfaches Verfahren zur kontinuierlichen Herstellung von Indium-haltigen Schichten durch metallorganische Gasphasenabscheidung oder -epitaxie bereitgestellt. Gefahren bei der Handhabung von festen pyrophoren Indiumalkylverbindungen werden durch die Verwendung einer Lösung vermieden oder deutlich reduziert Dadurch sinken die Gefahren durch Explosionen und Entzündungen bereits beim Hersteller der Indiumalkylverbindung, der diese direkt in Lösung bereitstellen, lagern und transportieren kann. Gefährdungen werden auch bei der Dosierung, bei der Befüllung der Anlage und bei der Durchführung des Verfahrens vermieden.

Die Verwendung von Lösungen in Niedrigsiedern ermöglicht eine deutliche Erhöhung des Massendurchsatzes der Indiumverbindung in der Gasphase. Dagegen sind bei Verfahren gemäß dem Stand der Technik mit Bubblern und festen Indiumalkylverbindungen, auch in Form von Suspensionen, keine hohen Massendurchsätze erreichbar, weil die Sättigung der Gasphase mit Indiumalkylverbindungen durch den festen Aggregatzustand und die Dimensionen des Bubblers thermodynamisch begrenzt ist. Die Verwendung von Lösungen ermöglicht auch eine genauere Dosierung und flexible und schnelle Anpassung der eingebrachten Lösungsmenge an die Prozesserfordernisse. Ein weiterer Vorteil ist, dass der gemäß dem Stand der Technik notwendige regelmäßige Austausch von Feststoffzylindern mit Resten von pyrophoren Indiumalkylverbindungen nicht erforderlich ist. Das Verfahren kann daher über längere Zeiträume kontinuierlich durchgeführt werden. Wegen der Verwendung von Lösungen kann eine vollständige Einbringung der Ausgangsstoffe in den Prozess erfolgen, was aus wirtschaftlichen und ökologischen Gründen wünschenswert ist. Ein weiterer Vorteil ist, dass das Lösungsmittel nicht reagiert und daher aufbereitet und wiederverwertet werden könnte. Das Verfahren ist auch ökonomisch vorteilhaft, weil niedrigsiedende Alkane oder Aromaten in großen Mengen verfügbar und daher nicht teuer sind.

### Beispiele

### Abscheidebedingungen:

Die Abscheidungen wurden an einem Aixtron AIX 200-GFR-Reaktorsystem durchgeführt. Als Trägergas diente Wasserstoff (H2) mit einer Flussrate von 6800 mL/min. Die Abscheidungen erfolgten bei 50 mbar. Die Temperaturkalibrierung erfolgte durch Vergleich mit dem Schmelzpunkt des Aluminium-Silicium-Eutektikums (Schmp. 577°C).

Als Gruppe III-Quellen dienten eine Lösung von Trimethylindium in Toluol mit einer Konzentration von 30 mol-% (im Folgenden auch als Liquid In bezeichnet), Trimethylgallium (DockChemicals) sowie Trimethylaluminium (EMF), als Gruppe V-Quellen diente tert.-Butylphosphin (DockChemicals).

Es wurden zwei verschiedene Schichttypen abgeschieden:
1) ((Al_{0.3}Ga_{0.7})_{0.5}In_{0.5})P-Doppelheterostruktur mit einer Wachstumsrate von 1.53 µm/h. Das Verhältnis der Gruppe V zu Gruppe III-Präkursoren betrug 96, die Abscheidetemperatur lag bei 685°C. Die so abgeschiedene Schicht wurde für die Photolumineszenzmessungen verwendet.
2) ((Al_{0.7}Ga_{0.3})_{0.5}In_{0.5})P-Mehrschichtstruktur für SIMS-Messungen. Hierbei wurden verschiedene Temperaturprofile und auch Gruppe V zu Gruppe III-Präkursoren-Verhältnisse untersucht: V/III = 25, 50 und 100, T = 625, 655, 670, 685°C. Die so abgeschiedene Schicht wurde für SIMS-Messungen (Sekundärionenmassenspektrometrie) verwendet.

### Photolumineszenz-Messungen:

Die Schichten wurden mittels Anregung durch einen Nd-YAG-Laser auf ihre Photolumineszenz hin untersucht. Als Vergleich dienten zwei Proben, die bei der Firma NAsP als Referenz verwendet werden. Ihre Photoeigenschaften dienen als obere bzw. untere Grenzen und dienen zur Qualifizierung von Proben. Der Aufbau der Messung ist in Figur 2 dargestellt.

Verunreinigungen und Kristalldefekte in den Schichten lassen sich in Photolumineszenzspektren erkennen: Je breiter der Photopeak (FWHM in Tabelle 1) bzw. je niedriger die abgestrahlte Photointensität (d. h. integrated Intensity in Tabelle 1), desto schlechter ist die Qualität der untersuchten Schicht.

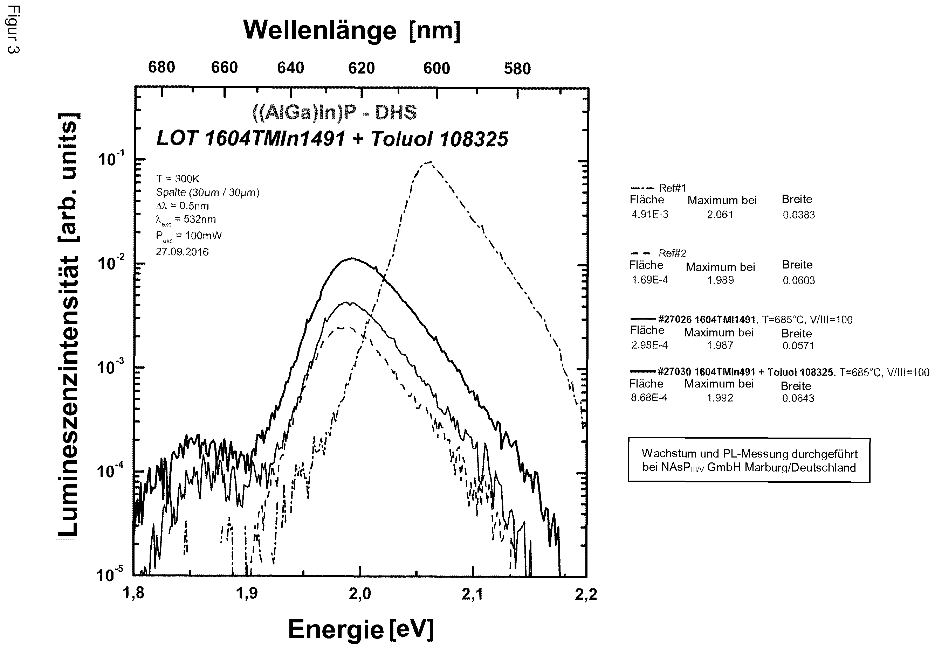

Figur 3 zeigt Photolumineszenzspektren der unter Verwendung von Liquid In erhaltenen Probe (27030, dicke schwarze durchgezogene Linie, oberhalb), einer Vergleichsprobe mit reinem Trimethylindium als Vergleichsbeispiel (27026, dünne schwarze durchgezogene Linie) und der beiden Referenzproben (Ref 1 und Ref 2, mit Strich-Punkt gezeichnete bzw. gestrichelte Linien).

Wie aus Figur 3 und Tabelle 1 ersichtlich, liegt die Schicht, die aus Liquid In abgeschieden wurde, von seinen Eigenschaften her zwischen (integrated Intensity) oder nahe bei den beiden Referenzwerten (FWHM bzw. Halbwertsbreite) und ist damit als Präkursor für indiumhaltige Schichten geeignet.

**Tabelle 1: Auswertung der Photolumineszenzmessung der AlGaInP-DH Strukturen**

| | **27026** | **27030** | **Ref 1** | **Ref 2** |
|---|---|---|---|---|
| **Integrated Intensity [a.u.]** | 2,98*10⁻⁴ | 8,68*10⁻⁴ | 4,91 *10⁻³ | 1,69*10⁻⁴ |
| **λ_{Peak} [eV]** | 1,987 | 1,992 | 2,061 | 1,992 |
| **FWHM [eV]** | 0,0571 | 0,0643 | 0,0383 | 0,0603 |

### SIMS-Messungen:

Sekundärionenmassenspektrometrie gibt einen Aufschluss darüber, welche und wieviele Verunreinigungen in einer Probe vorhanden sind.

Die Schichten für die SIMS-Messungen (Schicht 2) wurden hergestellt, indem auf einem Substrat Abscheidungen durchgeführt wurden, bei denen zum einen die Abscheidetemperatur sukzessive gesteigert als auch die Verhältnisse der Konzentrationen der Gruppe V- zu Gruppe III-Quellen variiert wurden.

Dies bedeutet, dass eine Schichtstruktur mit 9 Schichten abgeschieden wurde, die sich jeweils in ihrer Abscheidungstemperatur und der Verhältnisse der Gruppe V- zu Gruppe III-Quellen unterscheiden.

In Figur 4 sind diese Verhältnisse als untere Zahlenreihe im Diagramm aufgeführt (Werte von 100, 50, 100, 50, 25, 100, 50, 25, 100), in der Zahlenreihe darüber sind die Abscheidetemperaturen angegeben.

Besispielsweise ist zu erkennen, dass der Kurvenverlauf der schwarzen Kurve auf der rechten Seite ein hohes Plateau aufweist, was sich bei Abscheidetemperaturen von 625°C, unabhängig vom Verhältnis der Gruppe V zu Gruppe III-Quellen bildet.

Der Fachmann kann anhand der Sauerstoff-/Kohlenstoff-Einbaurate in Abhängigkeit der Gruppe V/Gruppe III-Quellen-Verhältnisse und der Abscheidetemperaturen Aussagen über die Reinheit der Schichten und damit über die verwendeten Präkursoren machen.

In Figur 4 ist die SIMS-Messung einer durch Verwendung von Liquid In als Indiumquelle erhaltenen Probe abgebildet. Die Bedingungen der Schichtabscheidung sind oben angegeben.

In dem SIMS-Spektrum sind der Gehalt an Sauerstoff (durchgezogene Linie) und Kohlenstoff (gestrichelte Linie) dargestellt. Die untersuchten Schichten wurden bei verschiedenen Temperaturen durchgeführt (obere Zahlenreihe in °C) und bei verschiedenen Gruppe V zu Gruppe III-Verhältnissen (untere Zahlenreihe). Mittels SIMS-Messungen konnte überraschend kein auffälliger Einbau von Kohlenstoff oder Sauerstoff in den Schichten beobachtet werden. Der erhöhte Kohlenstoffeinbau bei 655°C und einem Verhältnis von 25 kann auf eine unzureichende Zersetzung der Gruppe III-Präkursoren zurückgeführt werden, ein Beobachtung, die häufig bei Abscheidungen mit Trimethylindium gemacht wird. Der erhöhte Sauerstoffeinbau im Temperaturbereich von 625°C ist auf Sauerstoffverunreinigungen zurückzuführen, die aus den Gruppe V-Präkursoren eingeschleppt wurden.

### BEZUGSZEICHENLISTE

- 1: Zufuhr Lösung
- 2: Direktverdampfer
- 3: Ventil
- 4: Reaktionskammer
- 5: Flüssigkeitsdurchflussregler
- 6: Flüssigkeitszufuhrleitungen
- 8: Heizeinrichtung
- 9: Mischkammer
- 11: Zufuhr Trägergas
- 12: Gasdurchflussregler
- 13: Ventil
- 16, 18: Gaszufuhrleitungen
- 17: Gasabfuhrleitung

## Patentansprüche

1. Verfahren zur Herstellung einer Indium-haltigen Schicht durch metallorganische Gasphasenabscheidung, wobei die Indium-haltige Schicht in einer Reaktionskammer (4) auf einem Substrat erzeugt wird, wobei das Indium dem Verfahren in Form einer Indium-haltigen Vorläuferverbindung zugeführt wird, welche die Formel InR₃ aufweist, wobei die Reste R unabhängig voneinander ausgewählt sind aus Alkylresten mit 1 bis 6 C-Atomen,
**dadurch gekennzeichnet, dass** das Zuführen der Indium-haltigen Vorläuferverbindung in einer Lösung, bestehend aus
(a) 5 bis 60 Gew.-% einer Verbindung der Formel InR₃, wobei R unabhängig voneinander ausgewählt ist aus Alkylresten mit 1 bis 6 C-Atomen, und
(b) 40 bis 95 Gew.-% mindestens eines Kohlenwasserstoffs, der 5 bis 8 Kohlenstoffatome aufweist, erfolgt.

2. Verfahren gemäß Anspruch 1, wobei die metallorganische Gasphasenabscheidung eine metallorganische Gasphasenepitaxie ist.

3. Verfahren gemäß mindestens einem der vorhergehenden Ansprüche, wobei die Vorläuferverbindung Trimethylindium ist.

4. Verfahren gemäß mindestens einem der vorhergehenden Ansprüche, wobei das Lösungsmittel mindestens ein Alkan und/oder einen Aromaten aufweist.

5. Verfahren gemäß mindestens einem der vorhergehenden Ansprüche, wobei das Lösungsmittel Pentan, Hexan, Heptan, Oktan, Toluol, Benzol, Xylol oder ein Gemisch davon ist.

6. Verfahren gemäß mindestens einem der vorhergehenden Ansprüche, wobei die Lösung vor Einführung in die Reaktionskammer (4) mit einem Direktverdampfer (2) in die Gasphase überführt wird.

7. Verfahren gemäß Anspruch 6, wobei der Direktverdampfer (2) eine Temperatur von 0°C bis 100°C, bevorzugt zwischen 10°C und 50°C, und/oder einen Druck von 50 mbar bis 1200 mbar aufweist.

8. Verfahren gemäß mindestens einem der Ansprüche 6 oder 7, wobei die Gasphase vor Einbringen in die Reaktionskammer (4) mit einem Trägergas vermischt wird.

9. Verfahren gemäß Anspruch 8, wobei der Direktverdampfer (2) eine Mischkammer (2) aufweist, in der die Gasphase in mit einem Trägergas vermischt wird.

10. Verfahren gemäß mindestens einem der Ansprüche 6 bis 9, wobei der Direktverdampfer (2) einen Flüssigkeitsdurchflussregler (5), einen Gasdurchflussregler (12), eine Mischkammer (2) und ein Mischventil aufweist.

11. Verfahren gemäß mindestens einem der vorhergehenden Ansprüche, wobei mindestens eine weitere reaktive Substanz in die Reaktionskammer (4) eingeleitet wird.

12. Verwendung einer Lösung, bestehend aus
(a) 5 bis 60 Gew.-% einer Verbindung der Formel InR₃, wobei R unabhängig voneinander ausgewählt ist aus Alkylresten mit 1 bis 6 C-Atomen, und
(b) 40 bis 95 Gew.-% mindestens eines Kohlenwasserstoffs, der 5 bis 8 Kohlenstoffatome aufweist, zur Herstellung einer Indium-haltigen Schicht durch metallorganische Gasphasenabscheidung.

## Claims

1. Method for producing an indium-containing layer by metal-organic vapor phase deposition, wherein the indium-containing layer is generated on a substrate in a reaction chamber (4), wherein the indium is supplied to the method in the form of an indium-containing precursor compound with the formula InR₃, wherein the radicals R, independently of one another, are selected from alkyl radicals with 1 to 6 C-atoms,
**characterized in that** the supply of the indium-containing precursor compound occurs in a solution consisting of
(a) 5 to 60 wt% of a compound of formula InR₃, wherein R is selected from alkyl radicals with 1 to 6 C-atoms, independently of one another, and
(b) 40 to 95 wt% of at least one hydrocarbon which has 5 to 8 carbon atoms.

2. Method according to claim 1, wherein the metal-organic vapor deposition is a metal-organic vapor epitaxy.

3. Method according to at least one of the preceding claims, wherein the precursor compound is trimethylindium.

4. Method according to at least one of the preceding claims, wherein the solvent has at least one alkane and/or an aromatic.

5. Method according to at least one of the preceding claims, wherein the solvent is pentane, hexane, heptane, octane, toluene, benzene, xylene, or a mixture thereof.

6. Method according to at least one of the preceding claims, wherein the solution is converted into the vapor phase using a direct evaporator (2) before introducing it into the reaction chamber (4).

7. Method according to claim 6, wherein the direct evaporator (2) has a temperature of 0 °C to 100 °C - preferably, between 10 °C and 50 °C - and/or a pressure of 50 mbar to 1,200 mbar.

8. Method according to at least one of claims 6 or 7, wherein the vapor phase, before it is introduced into the reaction chamber (4), is mixed with a carrier gas.

9. Method according to claim 8, wherein the direct evaporator (2) has a mixing chamber (2) in which the vapor phase is mixed with a carrier gas.

10. Method according to at least one of claims 6 through 9, wherein the direct evaporator (2) has a liquid flow rate regulator (5), a gas flow rate regulator (12), a mixing chamber (2), and a mixing valve.

11. Method according to at least one of the preceding claims, wherein at least one additional reactive substance is delivered into the reaction chamber (4).

12. Use of a solution consisting of
(a) 5 to 60 wt% of a compound of formula InR₃, wherein R is selected from alkyl radicals with 1 to 6 C-atoms, independently of one another, and
(b) 40 to 95 wt% of at least one hydrocarbon which has 5 to 8 carbon atoms, for the production of an indium-containing layer by means of metal-organic vapor phase deposition.

## Revendications

1. Procédé de fabrication d'une couche contenant de l'indium par dépôt en phase vapeur aux organométalliques, la couche contenant de l'indium étant produite dans une chambre de réaction (4) sur un substrat, l'indium étant introduit dans le procédé sous la forme d'un composé précurseur contenant de l'indium, qui présente la formule InR₃, les radicaux R étant choisis, indépendamment les uns des autres, parmi les radicaux alkyle comprenant 1 à 6 atomes de carbone,
**caractérisé en ce que** l'introduction du composé précurseur contenant de l'indium a lieu dans une solution constituée de
(a) 5 à 60 % en poids d'un composé de la formule InR₃, R étant choisi, indépendamment les uns des autres, parmi les radicaux alkyle comprenant 1 à 6 atomes de carbone et
(b) 40 à 95 % en poids d'au moins un hydrocarbure, qui possède 5 à 8 atomes de carbone.

2. Procédé selon la revendication 1, dans lequel le dépôt en phase vapeur aux organométalliques est une épitaxie en phase vapeur aux organométalliques.

3. Procédé selon au moins l'une quelconque des revendications précédentes, dans lequel le composé précurseur est le triméthylindium.

4. Procédé selon au moins l'une quelconque des revendications précédentes, dans lequel le solvant comprend au moins un alcane et/ou un composé aromatique.

5. Procédé selon au moins l'une quelconque des revendications précédentes, dans lequel le solvant est le pentane, l'hexane, l'heptane, l'octane, le toluène, le benzène, le xylène ou un mélange de ceux-ci.

6. Procédé selon au moins l'une quelconque des revendications précédentes, dans lequel la solution est convertie en phase gazeuse à l'aide d'un évaporateur direct (2) avant l'introduction dans la chambre de réaction (4).

7. Procédé selon la revendication 6, dans lequel l'évaporateur direct (2) présente une température de 0 °C à 100 °C, de préférence entre 10 °C et 50 °C, et/ou une pression de 50 mbars à 1 200 mbars.

8. Procédé selon au moins l'une quelconque des revendications 6 ou 7, dans lequel la phase gazeuse est mélangée avec un gaz vecteur avant l'introduction dans la chambre de réaction (4).

9. Procédé selon la revendication 8, dans lequel l'évaporateur direct (2) comprend une chambre de mélange (2) dans laquelle la phase gazeuse est mélangée avec un gaz vecteur.

10. Procédé selon au moins l'une quelconque des revendications 6 à 9, dans lequel l'évaporateur direct (2) comprend un régulateur de débit de liquide (5), un régulateur de débit de gaz (12), une chambre de mélange (2) et une vanne de mélange.

11. Procédé selon au moins l'une quelconque des revendications précédentes, dans lequel au moins une autre substance réactive est introduite dans la chambre de réaction (4).

12. Utilisation d'une solution constituée de
(a) 5 à 60 % en poids d'un composé de la formule InR₃, R étant choisi, indépendamment les uns des autres, parmi les radicaux alkyle comprenant 1 à 6 atomes de carbone et
(b) 40 à 95 % en poids d'au moins un hydrocarbure, qui possède 5 à 8 atomes de carbone, pour la fabrication d'une couche contenant de l'indium par dépôt en phase vapeur aux organométalliques.
